# EUROPÄISCHE PATENTANMELDUNG

(11) **EP 2 784 524 A1**
(43) Veröffentlichungstag der Anmeldung: **01.10.2014**
(21) Anmeldenummer: 14161544.3
(22) Anmeldetag: 25.03.2014
(51) Int. Cl.: G01R 31/11, G11C 27/02, G01R 19/25

(54) **Impedanz-Scanner**

(30) Priorität: 25.03.2013 DE 102013005178
(71) Anmelder: Frohn, Wolf-Georg, 38302 Wolfenbüttel (DE)
(72) Erfinder: Frohn, Wolf-Georg, 38302 Wolfenbüttel (DE); Zimmerling, Detlef, 74246 Eberstadt (DE)
(74) Vertreter: Gritschneder, Sebastian

(57) **Zusammenfassung**

Das Zeitbereichsreflektometer zur Ermittlung und Analyse von Lauflängen und Reflexionscharakteristika von elektromagnetischen Wellen und Signalen umfasst einen Impulsgenerator (26) zur Erzeugung einer Impulsserie mit der die zu untersuchende Leitung (10) beaufschlagt wird, eine Verzögerungsschaltung (24) zur inkrementellen Abtastung periodischer Testsignale, ein Abtast-Halte-Glied (20) zur Aufnahme der momentanen Amplitude des Testsignals, einen AD-Wandler (12), zur Umwandlung des analogen Testsignals in einen digitalen Wert, und ein grafisches Display (24) zur Anzeige des erfassten Testsignals, wobei das Abtast-Halte-Glied (20) als separates Schaltungselement dem AD-Wandler (12) vorangeschaltet ist und einen Spitzengleichrichter (22) sowie einen Speicherkondensator (34) umfasst.

## Beschreibung

Die vorliegende Erfindung betrifft eine Vorrichtung und ein Verfahren zur Durchführung von Zeitbereichsreflektometrie zur Ermittlung und Analyse von Lauflängen und Reflexionscharakteristika von elektromagnetischen Wellen und Signalen, umfassend einen Impulsgenerator zur Erzeugung einer Impulsserie mit der die zu untersuchende Leitung (engl. Line under Test, kurz LUT) beaufschlagt wird, eine Verzögerungsschaltung zur inkrementellen Abtastung periodischer Testsignale, ein Abtast-Halte-Glied zur Aufnahme der momentanen Amplitude des Testsignals, ein AD-Wandler, zur Umwandlung des analogen Testsignals in einen digitalen Wert, sowie ein grafisches Display zur Anzeige des erfassten Testsignals.

Die Zeitbereichsreflektometrie, auch unter der englischen Bezeichnung Time Domain Reflectometry, kurz TDR, bekannt dient unter anderem dazu, Störstellen (Abweichungen von Standardwerten) bei elektrischen Leitungen, insbesondere bei Koaxialkabeln, zu ermitteln. Im Wesentlichen erzeugt dabei ein Impulsgenerator eine Folge von Rechteckimpulsen, die auf den Eingang eines Koaxialkabels geleitet werden. Bei einem Koaxialkabel mit offenem Kabelende werden die Impulse am offenen Ende mit gleicher Polarität reflektiert (Addition der Spannungspegel). Ist dagegen das Ende des Koaxialkabels kurzgeschlossen, so werden die Impulse mit entgegengesetzter Polarität reflektiert (Subtraktion der Spannungspegel). An Störstellen innerhalb des Kabels oder allgemeiner ausgedrückt an allen Stellen, an denen sich die Impedanz des Koaxialkabels merklich ändert, treten ebenfalls Reflektionen auf, bei denen der Reflexionsgrad je nach Änderung der Impedanz variiert. Die Überlagerung eines Rechteckimpulses mit den Reflexionssignalen von der LUT ergibt ein Testsignal, welches in der Zeitbereichsreflektometrie ausgewertet wird.

Die Hochfrequenz-Eigenschaften beeinflussen die Datenübertragung von Koaxialkabeln in starkem Maße. Ein Anwendungsgebiet der TDR ist daher das Ermitteln des Verlaufes der Impedanz über die gesamte Kabellänge und das Lokalisieren von Störstellen, damit diese beurteilt und gezielt behoben werden können. Um die Position der Störstellen hinreichend genau lokalisieren zu können, also mit einer Genauigkeit der Störstellenlokalisierung von unter 0,1 m, muss die TDR mit einer effektiven zeitlichen Auflösung des Testsignals von unter 1 ns realisiert werden können. Die Impedanz einer elektrischen Leitung ist sowohl von der konstruktiven Anordnung der Leiter als auch dem die Leitung umgebenden Dielektrikum abhängig. Zeitliche und räumliche Änderungen haben messbaren Einfluss auf die Impedanz der Messanordnung. Durch Einbringen zweier parallel angeordneter Leiter in den Probekörper einer Frischbetonmischung kann der Aushärtevorgang einer Betonmischung (engl. curing) nahezu kontinuierlich erfasst und bewertet werden. Der Anteil des nicht gebundenen, freien Wassers bestimmt wesentlich die relative Änderung der Impedanz der Messanordnung. Der zeitliche Verlauf der Impedanzänderung gibt Aufschluss über die Zunahme der Betonfestigkeit. Effektiv hohe zeitliche Auflösung der Messanordnung vorausgesetzt, können sogar Inhomogenitäten innerhalb des Probekörpers deutlich gemacht werden.

In Anwendungsbereichen in denen die Impedanz der LUT deutlich größer ist als der Innenwiderstand des Testsignalgenerators, d.h. bei Impedanzen >200 Ohm, werden der Spannungsteilerregel entsprechend die Änderungen der Amplitude des Testsignals sehr klein, so dass hier eine hohe effektive Auflösung des Analog/Digitalwandlers erforderlich ist, um die Spannungsunterschiede noch hinreichend genau auflösen zu können.

Moderne High-Tech TDR arbeiten hierzu bis in den Frequenzbereich GHz und ermöglichen daher eine zeitliche Auflösung im Picosekunden Bereich. Diese hochleistungsfähigen Geräte sind jedoch sehr teuer und setzen ein hohes Maß an Fachkenntnis des Anwenders in HF Messtechnik voraus. Aufgrund des hohen Anschaffungspreises stehen diese Geräte für den alltäglichen Einsatz in Qualitätsmanagement, Servicedienstleistungen und insbesondere in der Ausbildung in der Regel nicht zur Verfügung.

Derzeit sind auch kostengünstigere TDR auf dem Markt erhältlich, in denen preiswerte Flash AD-Wandler eingesetzt werden, die eine Eingangsstufe mit einem internen Abtast-Halte-Glied (engl. Track&Hold) aufweisen, um typische Fehler während der Analog/Digitalwandlung, die insbesondere bei sich schnell ändernden Signalen auftreten können, zu vermeiden. Track&Hold bedeutet, dass das analoge Signal nicht kontinuierlich in ein digitales Signal umgewandelt wird, sondern dass das analoge Signal in relativ kurzer Zeit erfasst und in einen digitalen Wert umgewandelt wird. Ein zu einem bestimmten Zeitpunkt gemessener analoger Wert wird jeweils für eine kurze Zeit zwischengespeichert. Die Zeitspanne über das analoge Signal zwischengespeichert wird, bestimmt dabei die zeitliche Auflösung des AD-Wandlers. Herkömmliche, schnelle AD-Wandler mit Abtastraten von 10 bis 50 MHz benötigen 2 bis 10 ns für das Erfassen des Spannungswertes. In dieser Zeit legt das Testsignal ca. 0,6 bis 3 m Kabellänge zurück, und begrenzt hiermit die Genauigkeit der Störstellenortung. Zur Lokalisierung von Störstellen in Hochfrequenzleitungen wird jedoch eine Genauigkeit von mind. 0,1 m benötigt.

Ein weiterer Nachteil herkömmlicher AD-Wandler ist außerdem, dass die effektive Auflösung erheblich reduziert ist, je kürzer die Abtastzeit gewählt wird. Bei Abtastzeiten von unter 3 ns ist die spezifizierte Auflösung von 8-bit be weitem nicht mehr zu erreichen. Je geringer die Auflösung wird, desto höher ist jedoch die Wahrscheinlichkeit, dass Störstellen der LUT nicht mehr detektiert werden können. Besonders nachteilig wirkt sich dies bei Anwendungsbereichen aus, in denen die Impedanz der LUT deutlich größer ist als der Innenwiderstand des Testsignalgenerators, d.h. bei Impedanzen >200 Ohm. Aufgrund der geringfügigen Änderungen der Amplitude des Testsignals, kann hierbei nur durch eine hohe effektive Auflösung des Analog/Digitalwandlers eine zuverlässige Störstellenerkennung gewährleistet werden.

In der Patentschrift US 5 521 512 ist ein TDR beschrieben, welches eine 50 MHz Clock als Taktgeber aufweist. Von diesem Taktgeber wird ein Impulsgenerator gesteuert, der eine Folge von Rechteckpulsen auf die zu untersuchende Leitung sendet. Der erste Rechteckpuls wird ohne Verzögerung an die LUT angelegt. Jeder weitere Rechteckpuls ist gegenüber dem ersten Impuls dagegen um ein Testintervall zuzüglich einer Verzögerung (Delay) von 1/8 der Taktfrequenz verzögert. Ein Messschaltkreis wird ebenfalls vom zentralen Taktgeber angesteuert und misst in gleichbleibenden Abständen die Reflexionssignale von der LUT, wobei die aufeinanderfolgenden Reflexionssignale zu unterschiedlichen Zeitintervallen gemessen werden. Damit wird es effektiv ermöglicht mit einem relativ langsamen AD-Wandler eine Abtastrate des 8-fachen der Taktfrequenz, nämlich 400 MHz zu erreichen. Dies entspricht einer zeitlichen Auflösung von 2,5 ns bzw. ≥ 0,8 m Kabellänge. Zwar ist in der US 5 521 512 angegeben, dass auch höhere Frequenzen verwendet werden können, jedoch ist die zeitliche Auflösung dieses Verfahrens durch die erforderliche Abtastzeit der Track&Hold Stufe des AD-Wandlers begrenzt. Bei schnellen AD-Wandlern mit 8-Bit Auflösung liegt die erforderliche Abtastzeit der Track&Hold-Stufe bei etwa 7 ns. Kürzere Abtastzeiten können nur dadurch erreicht werden, dass eine geringere effektive Auflösung der AD-Wandlung in Kauf genommen wird. Kriterien der effektiven Auflösung von AD-Wandlern können der einschlägigen Fachliteratur entnommen werden.

Ein ähnliches TDR ist in der EP 0 652 442 beschrieben, umfassend einen Impulsgenerator zum Erzeugen einer Testimpulsfolge, ein programmierbares Verzögerungsglied, mit dem die Prüfimpulse verzögert an die zu testende Leitung angelegt werden können und einen Analog-Digital-Wandler, der das reflektierte Signal aus der Leitung sequenziell abtastet und die Messwerte an ein Speicherelement weitergibt. Das Verzögerungsglied verschiebt die Startzeit der Testimpulse jeweils um das 1 / n-fachen der Abtastperiode. Anschließend werden die Abtastwerte in der Reihenfolge zunehmender Zeitdifferenz zwischen dem Senden des Testimpulses und Abtastung umgeordnet und angezeigt. Die Vorrichtung hat grundsätzlich den Vorteil, dass die zeitliche Auflösung des Geräts nicht von der Taktfrequenz, sondern nur durch das minimale Verzögerungsinkrement des Verzögerungsgenerators sowie von der Abtastdauer des A/D-Wandlers begrenzt ist. Das kleinste Zeitinkrement beträgt hierbei 3 ns. Dieses Verfahren könnte theoretisch mit kleineren Zeitinkrementen von unter 1 ns durchgeführt werden. Jedoch sind herkömmliche A/D-Wandler nicht in der Lage bei solch kurzen Abtastraten ausreichende hohe effektive Auflösung der AD-Wandlung zu gewährleisten. Eine höhere zeitliche Auflösung kann daher mit konventionellen, kostengünstigen Flash AD-Wandlern nicht erreicht werden.

Aufgabe der vorliegenden Erfindung ist es daher, eine Vorrichtung und ein Verfahren bereitzustellen, welche/es mit kostengünstigen Mitteln eine zeitliche Auflösung von unter 1 ns und gleichzeitig eine effektive Auflösung des A/D-Wandlers von mindestens 10 bit ermöglicht.

Diese Aufgabe wird bei einem Zeitbereichsreflektometer der eingangs genannten Art dadurch gelöst, dass das Abtast-Halte-Glied als ein separates Schaltungselement umfassend einen Spitzengleichrichter und einen Speicherkondensator eingesetzt wird, welches dem AD-Wandler vorangeschaltet ist, und die momentane Spannung des Testsignals für einen Zeitraum im µs-Bereich auf einem Speicherkondensator hält. Dies ermöglicht den Einsatz eines verhältnismäßig langsamen aber hochauflösenden AD-Wandlers.

Das erfindungsgemäße Zeitbereichsreflektometer ermöglicht eine Auflösung, die der Auflösung von High-End-Reflektometern nahe kommt, die im GHz-Bereich arbeiten und eine Auflösung im 100 ps-Bereich aufweisen. Da die erfindungsgemäße Schaltung mit elektronischen Standardbauelementen realisiert werden kann, ist das vorliegende Zeitbereichsreflektometer kostengünstiger und durch Beschränken der Anwendungsbreite deutlich einfacher zu bedienen.

Der Spitzengleichrichter umfasst zwei sehr schnelle Schottky-Dioden äußerst geringer Kapazität mit gemeinsamer Anode. Schottky-Dioden haben eine niedrigere Durchgangsspannung U_{F} (Spannungsabfall in Durchlassrichtung) und in diesem Fall extrem kürzere Schaltzeiten als konventionelle Dioden. Sie sind aus diesem Grund besonders für den Einsatz in dem Gleichrichter des Abtast-Halte-Glieds des vorliegenden Zeitbereichsreflektometers geeignet. Vorzugsweise ist das Abtast-Halte-Glieds diskret aufgebaut.

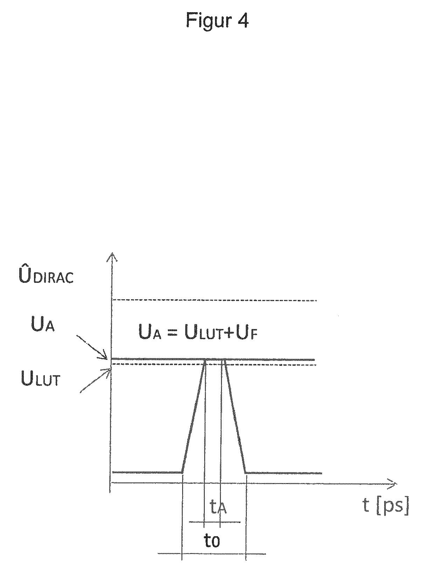

Der Spitzengleichrichter wird von einem sogenannten Dirac-Impuls an der gemeinsamen Anode angesteuert. Ein Dirac-Impuls ist ein Impuls mit extrem hoher Flankensteilheit und von kurzer Dauer, vorzugsweise deutlich unter 1 ns. Solange der Spannungspegel des Dirac-Impulses Û_{DIRAC}, um die Durchlassspannung U_{F} der Schottky-Diode größer ist als der Momentanwert der an den jeweiligen Kathoden anliegenden Spannung, ist der Spitzengleichrichter im leitendem Zustand. Während dieser Zeit wird daher der aktuelle Wert des Testsignals von der LUT auf den Speicherkondensator übertragen. Entscheidend für die Dauer des leitenden Zustandes des Spitzengleichrichters ist dabei die Dachbreite des Dirac-Impulses, also die Zeitdauer t_{A} während der sich der Spannungswert Û_{DIRAC} des Dirac-Impulses oberhalb des Pegels des Testsignals U_{LUT} zuzüglich der für Schottky-Dioden typischen Durchlassspannung U_{F} von 0,3V befindet. (siehe Fig. 4). Der Dirac-Impuls wird über einen Widerstand an die gemeinsame Anode der Schottky-Dioden des Spitzengleichrichters angelegt. Das während der Ansteuerung durch den Dirac-Impuls aufgenommene Testsignal liegt dann für in etwa der Zeitdauer der Periode des Impulsgenerators an dem Speicherkondensator an.

Vorzugsweise besteht der Spitzengleichrichter ausschließlich aus den zwei entgegengesetzt geschalteten, sehr schnellen Schottky-Dioden.

Vorzugsweise ist der Dirac-Impuls kürzer als 3 ns und die Periode des Impulsgenerators größer als 100 ns. Weiter vorzugsweise ist der Dirac-Impuls kürzer als 1 ns und die Periode des Impulsgenerators größer als 1 µs. Besonders bevorzugt beträgt der Dirac-Impuls in etwa 250 ps und die Periode des Impulsgenerators etwa 10 µs.

Wie oben bereits erwähnt ist eine Reduzierung des Zeitinkrements alleine nicht ausreichend, um eine ausreichend schnelle (hohe örtliche Auflösung) und hohe (hohe Sensitivität) Auflösung des Reflexionssignals zu erhalten. Entscheidend ist auch, dass der eigentliche Messvorgang sowie die AD-Wandlung an das Zeitinkrement angepasst sind. Die Anpassung des Messvorgangs erfolgt bei der vorliegenden Erfindung über die Dauer des Diracimpulses, der den aktuellen Messwert des Reflexionssignal über einen Zeitraum bestimmt, der mit dem Zeitinkrement übereinstimmt.

Der Spitzengleichrichter überträgt das Signal während des Messvorgangs auf den Speicherkondensator, wobei die (geringe) Ladespannung nicht dem Reflexionssignal entzogen, sondern vom Diracsignal bereitgestellt wird. Gleich nach dem Diracsignal sorgt der Spitzengleichrichter dafür, dass der Speicherkondensator vom Rest der Schaltung entkoppelt wird, so dass die Ladung des Speicherkondensators während der AD-Wandlung durch einen konventionellen AD-Wandler mit hoch-ohmigen Eingang nahezu unbelastet ist. Dadurch kann das momentan gemessene Reflexionssignal über relativ lang Zeiträume von mehreren µs auf dem Speicherkondensator vorgehalten werden, so dass ein herkömmlicher (relativ langsamer) AD-Wandler mit hoher Auflösung zur Digitalisierung des Signals eingesetzt werden kann.

Der Speicherkondensator hat eine Kapazität, die deutlich geringer ist, als die Kapazität der LUT. Typischerweise weisen Koaxialkabel je nach Kabellänge eine Kapazität von über 500 pF auf. Der Speicherkondensator weist demgegenüber eine kleine Kapazität von unter 100 pF, vorzugsweise von unter 50 pF, z.B. etwa 22 pF, auf. Die Kapazität des Speicherkondensators kann dabei an die unterschiedlichen Anwendungsgebiete angepasst werden. Aufgrund der verhältnismäßig kleinen Kapazität des Speicherkondensators, wird nur ein relativ kleiner Ladestrom benötigt um den Spannungsausgleich zwischen der LUT und dem Speicherkondensator herzustellen und das Messergebnis für das Testsignal wird entsprechend nicht oder nur geringfügig beeinflusst.

Ein weiterer Vorteil der speziellen Beschaltung des Spitzengleichrichters liegt darin, dass solange die Spannung U_{C} am Kondensator geringer ist, als die momentane Spannung U_{LUT} des Testsignals, der gesamte benötigte Ladestrom für den Speicherkondensator vom Dirac-Generator zur Verfügung gestellt wird. Dadurch ist insbesondere zu Beginn des Messverfahrens gewährleistet, dass keine Verfälschung des Testsignals aufgrund des Ladungsausgleichs mit dem Speicherkondensator auftritt.

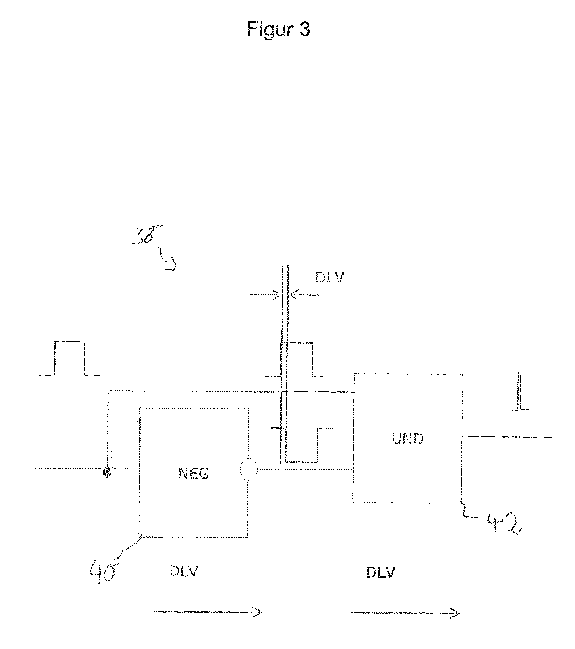

Der Dirac-Impuls wird vorzugsweise von einem HC- bzw. AC-Logikgatter in SMD-Bauform erzeugt. In einer einfachen Form wird für die Schaltung zur Erzeugung eines Dirac-Impulses lediglich ein Negator und ein UND-Glied benötigt, die entsprechend Fig. 3 geschaltet sind. Die Durchlaufverzögerung DLV des Negators bestimmt dabei die Pulsbreite t₀ des Dirac-Impulses. Dirac-Impulse können auch mit äquivalenten logischen Schaltungen erzeugt werden. Vorteilhafterweise wird dabei immer die kurze Durchlaufverzögerung eines Gliedes ausgenutzt, um die Impulsdauer des Dirac-Impulses zu begrenzen. Vorzugsweise werden die Logikgatter bei etwa 8V, oberhalb des Grenzbereiches ihrer Betriebsspannung betrieben. Dies erhöht die Schaltgeschwindigkeit der Logikgatter erheblich und verkürzt damit die Dachbreite t_{A} des Dirac-Impulses deutlich. Diese Beschaltung ermöglicht es, Dirac-Impulse mit einer Dachbreite t_{A} von etwa 250 ps zu erzeugen.

Wie in Fig. 4 angedeutet ist der Dirac-Impuls im Wesentlichen ein kurzer Impuls mit einer Fußbreite t₀, die der Durchlaufverzögerung eines Logik-Gliedes der Schaltung zur Erzeugung des Dirac-Impulses entspricht. Sobald der Dirac-Impuls einen Spannungswert Û_{DIRAC} = U_{A} erreicht, der der Summe der momentanen Spannung U_{LUT} des Testsignals, sowie der Durchlassspannung U_{F} der Schottky-Diode entspricht, wird die Spannung Û_{DIRAC} des Dirac-Impulses auf diese maximal Spannung U_{A} begrenzt.

Die Verwendung einer digital steuerbaren Verzögerungsschaltung zur inkrementellen Verschiebung der Abtastung gegenüber dem Testsignal ist bereits aus dem Stand der Technik bekannt. Als Verzögerungsglieder können bei der vorliegenden Erfindung beliebige, bewährte Verzögerungsglieder eingesetzt werden. Das Zeitinkrement des Verzögerungsglieds bildet dabei die untere Grenze für die maximal erreichbare zeitliche Auflösung im Zeitbereich. In einer bevorzugten Ausführungsform wird eine Verzögerungskaskade aus zwei Delay Lines (Verzögerungsgliedern) mit unterschiedlichen Zeitinkrementen verwendet, deren wirksame Verzögerung durch programmierbare 8-bit Register (2⁸ = 256 Werte) und ggf. einem vorgeschalteten programmierbaren Timer bestimmt wird. Die Zeitinkremente der beiden Verzögerungsregister sind dabei derart aufeinander abgestimmt sind, dass ein lückenloses und nicht überlappendes Zeitraster erzeugt werden kann. Das eine Verzögerungsglied kann ein Grundinkrement von 250 ps besitzen. Damit kann der Dirac-Impuls um bis zu 255 * 250 ps = 63,750 ns verzögert werden. Diese Signallaufzeit entspricht jedoch bei typischen Koaxialkabeln einer Kabellänge von maximal 9 m, so dass mit einem einzelnen 8-bit Register mit einem Zeitinkrement von 0,250 ns die überprüfbare Kabellänge auf maximal 9 m beschränkt wäre.

Das zweite Verzögerungsglied muss nun so gewählt werden, dass dessen Zeitinkrement in einem ganzzahligen definierten Verhältnis zum Zeitinkrement des ersten Verzögerungsgliedes steht. Beide 8-bit Register haben einen Wertebereich von 0 bis 255. Das Zeitinkrement des zweiten Verzögerungsgliedes muss dann z.B. 5ns betragen, was dem 20-fachen des ersten Verzögerungsgliedes entspricht. 240 Inkremente (240 * 250 ps = 60 ns) des ersten Registers decken dann exakt den Zeitbereich ab, der auch durch 12 Inkremente (12 * 5 ns = 60 ns) des zweiten Registers abgedeckt werden kann. Die 8-bit Register werden dann so programmiert, dass das erste Register jeweils den Wertebereich von 0 bis 239 durchläuft. Nach jedem Durchlauf des ersten Registers wird das zweite Register um 12 Werte erhöht, um einen zeitlichen Offset von 60 ns bzw. dem ganzahligen Vielfachen zu addieren. Mit seinen 256 Werten kann das zweite Register 21-mal um 12 Schritte weiterzählen (TRUNC 255/12 =21). Insgesamt ergibt sich mit dieser Beschaltung der beiden Register ein lückenloses Zeitraster mit einem kleinsten Zeitinkrement von 0,25 ns über einen Gesamtbereich von t_{ges} = (21 + 1) * 60 ns = 1,32 µs. Dies entspricht einer überprüfbaren Gesamtkabellänge von maximal 376 m, was für viele Anwendungen ausreichend sein dürfte.

Zusätzlich kann ein Timer (als Bestandteil eines Microcontrollers) vorgesehen werden, mit dem das Signal über einen zusätzlichen Offset von ganzzahligen Vielfachen von 1,32 µs verzögert werden kann. Oder allgemein ausgedrückt kann der Timer das Signal um ganzzahlige Vielfache des Gesamtzeitbereichs der Verzögerungskette verzögern. Damit ist es dann möglich auch längere Leitungen zu untersuchen. Eine Grenze der überprüfbaren Länge ergibt sich aber daraus, dass keine Leitung ideal ist und daher elektrische Verluste auftreten, die mit zunehmender Leitungslänge zu einer Verringerung der Signalamplitude führen. Ab einer gewissen Kabellänge sind diese Verluste so hoch, dass keine verlässliche Überprüfung des Kabels auf Störstellen mehr sinnvoll erscheint.

Das vom Frequenzgenerator erzeugte Rechtecksignal ist nicht nur Grundlage für das zu untersuchende Testsignal, sondern dient auch als zeitlicher Referenzpunkt t₀ für die Verzögerungsschaltung. Je steiler die Flanken des Testsignals, desto genauer ist der zeitliche Referenzpunkt definiert. Vorzugsweise wird daher das Rechtecksignal über eine "Pulse Performance"-Stufe geleitet, in der die Flankensteilheit des Rechtecksignals deutlich erhöht wird.

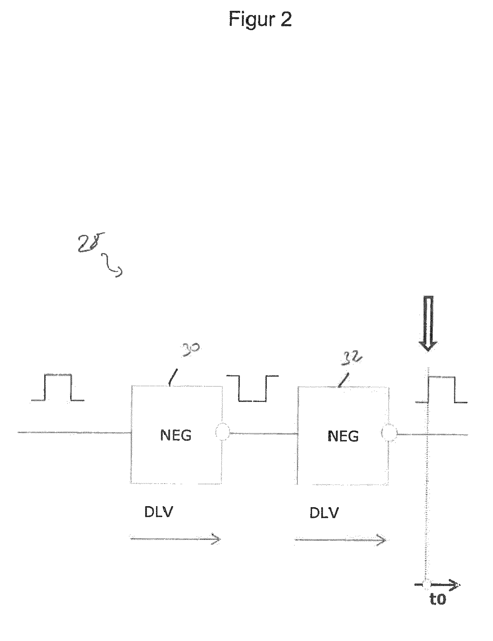

Die "Pulse Performance"-Stufe besteht vorzugsweise aus einer Reihe von HC- bzw. AC-Logikgattern, die zur Erhöhung ihrer Umschaltgeschwindigkeit im Grenzbereich der Betriebsspannung betrieben werden. Das Logikgatter kann z.B. zwei Negatoren umfassen, wie in Fig.2 gezeigt. Diese Schaltung lässt das Rechtecksignal im Wesentlichen unverändert passieren, erhöht jedoch aufgrund der erhöhten Betriebsspannung U_{B} die Flankensteilheit des Rechteckimpulses erheblich. Die Flankensteilheit kann um bis zu einem Faktor 10 und mehr erhöht werden. Eine hohe Flankensteilheit ist unter anderem deswegen nötig, weil die low-high-Flanke des Testimpulses den zeitlichen Referenzpunkt für die nachfolgende Signalanalyse bildet. Je steiler die Flanken des Rechteckimpulses, desto präziser ist daher der zeitliche Referenzpunkt definiert. Außerdem enthalten sehr steile Flanken hohe Frequenzanteile, die für das Messen der Leitungsimpedanz von Bedeutung sind.

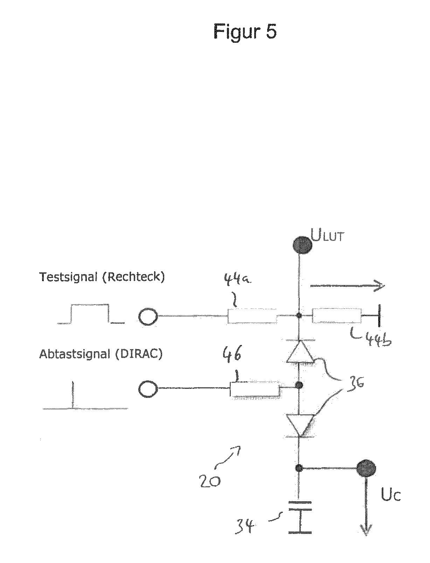

Vorteilhafterweise weist die "Pulse Performance"-Stufe des Rechtecksignals genauso viele Logikgatter auf, wie die Schaltung zur Generierung des Dirac-Impulses. Dann ist nämlich die Laufzeit der parallel laufenden Pulse gleich lang und es kommt zu keinen zusätzlichen Laufzeitunterschieden zwischen dem Testimpuls und dem Dirac-Impuls. Das Testsignal wird gemäß Fig. 5 mittels eines Spannungsteilers auf den Eingang der LUT gelegt. Der Spannungsteiler sorgt dafür, dass das maximal zu erwartende reflektierte Signal U_{LUT} von der LUT in jedem Falle eine kleinere Amplitude, als der Dirac-Impuls Û_{Dirac} aufweist. Vorzugsweise kann hierfür der Spannungsteiler so ausgelegt sein, dass das Testsignal mit halber Amplitude auf die LUT geleitet wird. Der Spannungsteiler kann dabei zwei Widerstände aufweisen deren Verhältnis die Amplitude des an die LUT angelegten Testsignals bestimmt. Vorzugsweise sind die beiden Widerstände gleich groß, so dass die an die LUT angelegte Amplitude um den Faktor 2 reduziert ist. Die beiden Widerstände können dabei an die Impedanz der LUT angepasst werden. Für Koaxialkabel mit einer Norm-Impedanz von 50 Ω können die beiden Widerstände zum Beispiel je 100 Ω aufweisen, um eine störungsfreie Einkopplung des Testsignals zu gewährleisten.

Bei einer Taktfrequenz von 100kHz liegt der abgetastete Wert des Testsignals für etwa 10 µs am Speicherkondensator an. Diese Zeitdauer ist lang genug, so dass ein hochauflösender AD-Wandler eingesetzt werden kann. Vorzugsweise kann hier ein 10 bzw.12-bit SAR AD-Wandler mit einer Umsetzungsrate von 1 MHz verwendet werden Dem AD-Wandler ist ein sog. Trennverstärker mit sehr hohen Eingangswiderstand vorgeschaltet, um die Belastung des Speicherkondensators klein zu halten. Daher kann die AD-Wandlung mit einer Auflösung von effektiv 10/12-bit realisiert werden. Da die Umsetzungsdauer mit 1 µs zudem deutlich unterhalb der Testperiode von 10 µs liegt, kann eine Mehrfachmessung (Oversampling) der gespeicherten Spannung mit nachfolgender Mittelwertbildung angewendet werden, um selbst unter Störeinflüssen verlässliche Ergebnisse zu erzielen. Mehrfachmessung (oversampling) mit nachfolgender Mittelwertbildung kann andererseits in aufeinanderfolgenden Perioden erfolgen, wobei der Abtastzeitpunkt innerhalb dieser Perioden konstant gehalten wird.

Anhand nachfolgender Abbildungen wird die Vorrichtung der vorliegenden Erfindung näher erläutert. Es zeigen:
- Fig. 1: eine Schaltskizze einer bevorzugten Ausführungsform der vorliegenden Erfindung;
- Fig. 2: eine Logikschaltung "Pulse Performance" zur Erhöhung der Flankensteilheit;
- Fig. 3: eine Logikschaltung zur Erzeugung eines Dirac-Impulses;
- Fig. 4: Spannungsverlauf eines Dirac-Impulses;
- Fig. 5: detaillierten Aufbau einer Ausführungsform des Abtast-Halte-Glieds.

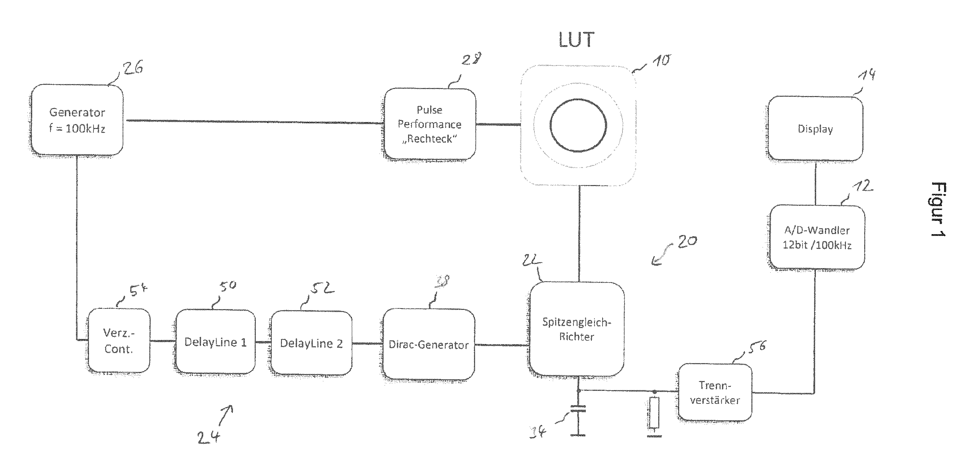

Das Schaltschema einer bevorzugten Ausführungsform eines erfindungsgemäßen Impedanz-Scanners ist in Fig. 1 abgebildet. Im Wesentlichen wird dabei, wie aus dem Stand der Technik bekannt, eine Serie von Rechtecksignalen über einen geeigneten Verbinder auf die zu untersuchende Leitung 10 (LUT) gegeben. Durch Reflexion an Störstellen entstehen Reflexionssignale, die dem ursprünglichen Rechtecksignal überlagert werden. Das aus dieser Überlagerung resultierende Testsignal, wird über einen an die LUT angeschlossenen AD-Wandler 12 ausgewertet und mittels eines grafischen Displays 14 wiedergegeben. Kernstück der Vorrichtung ist dabei ein separates Abtast-Halte-Glied 20 mit einem Spitzengleichrichter 22, der über einen extrem kurzen sogenannten Dirac-Impuls angesteuert wird, und dabei das Testsignal mit einer zeitlichen Auflösung von unter 1 ns abtastet.

Mittels einer Verzögerungsschaltung 24 (engl. delay line) wird der Dirac-Impuls sukzessive gegenüber dem Testrechtecksignal um ein Zeitinkrement Δ t verschoben, wobei das Testsignal in einer aus dem Stand der Technik beschriebenen Weise schrittweise vermessen wird. Das Testsignal kann dann über ein handelsübliches digitales Grafik-Display 14 angezeigt und analysiert werden.

Der in der Schaltskizze von Fig. 1 verwendete Frequenzgenerator 26 erzeugt ein Rechtecksignal mit einer Taktfrequenz von 100 kHz, was einer Pulsweite von 10 µs entspricht. Dieses Signal wird über eine "Pulse Performance"-Stufe 28 an die zu untersuchende Leitung 10, z.B. ein Koaxialkabel, geleitet. In der "Pulse Performance"-Stufe 28 wird die Flankensteilheit des Rechtecksignals erhöht. Dies kann dadurch erreicht werden, dass das Rechtecksignal an eine Logikschaltung entsprechend Fig. 2 angelegt wird. Die einzelnen HC- oder AC-Logikgatter, in diesem Beispiel zwei Negatoren 30, 32 werden dabei in ihrem Grenzbereich bei etwa 8 V betrieben, wodurch deren Umschaltgeschwindigkeit erhöht wird. Nach durchlaufen der "Pulse Performance"-Stufe 28 ist die Steilheit der Impulsflanken des Rechteckimpulses signifikant erhöht.

Nach der "Pulse Performance"-Stufe 28 wird das Testsignal über eine Widerstandskombination bestehend aus zwei 100 Ω Widerständen 44a, 44b, die einen Spannungsteiler bilden auf den Innenleiter der LUT 10 gelegt (siehe Figur 5).

Das von der LUT 10 reflektierte Signal wird über das Abtast-Halte-Glied 20 gemäß Figur 5, umfassend den Spitzengleichrichter 22 und einen Speicherkondensator 34 abgenommen. Der Spitzengleichrichter 22 umfasst zwei sehr schnelle Schottkydioden 36 (z.B. Typ: HSMS2813), die eine gemeinsame Anode aufweisen und entgegengesetzt angeordnet sind und daher in beiden Richtungen stromsperrend geschaltet sind, solange kein Dirac-Abtastsignal anliegt und die Schottkydioden 36 in den leitenden Zustand versetzt. Der Spitzengleichrichter 22 wird wie nachfolgend beschrieben von einem kurzen Impuls kurzfristig in den "ON"-Zustand, also in einen stromleitenden Zustand versetzt, wobei dann der aktuelle Spannungswert des Testsignals auf den Speicherkondensator 34 übertragen wird.

Bei dem Abtast-Halte Glied 20 gemäß Figur 5, werden die beiden Schottkydioden 36 in den leitenden Zustand versetzt sobald die Amplitude des Dirac-Impulses Û_{DIRAC} einen Spannungswert U_{A} = U_{LUT} + U_{F} erreicht. Die Spannungsdifferenz zwischen Û_{DIRAC} und U_{A} fällt dann am Widerstand 46 ab. Aufgrund der Auslegung des Abtast-Halte-Glieds 20 gemäß Fig.5 wird die daher die Spannung Û_{DIRAC} des Dirac-Impulses, wie in Fig. 4 angedeutet auf die Maximal-Spannung U_{A} begrenzt.

Da die Zeitdauer des Ansteuerungsimpulses maßgeblich ist für die zeitliche Auflösung des erfindungsgemäßen Reflektometers, wird der diskret aufgebaute Spitzengleichrichter 22 über einen extrem kurzen Dirac-Impuls angesteuert. Der Dirac-Impuls wird über eine Logikschaltung 38, nämlich über ein HC-Logikgatter entsprechend Fig. 3, welches aus einem Negator 40 und einem UND-Glied 42 besteht, erzeugt und über den Widerstand 46 an die Anoden der Schottky-Dioden 36 angelegt. Wie in Fig. 3 angedeutet löst die high-low-Flanke des Rechtecksignals den Dirac-Impuls aus. Die Dauer des Dirac-Impulses wird durch die Laufzeit des Negators 40 bestimmt, wobei die Laufzeit in der vorgeschlagenen Betriebsart (VCC = 8 Volt) und - durch die SMD Bauform begünstigt - im Bereich kleiner 500 ps liegt. Aufgrund der Durchlaufzeitverzögerung DLV liegt das negierte Signal am zweiten Eingang des UND-Glieds erst um einige 100 ps später an als das nicht-negierte Signal am ersten Eingang des UND-Glieds. Durch diesen Laufzeitunterschied ist der Ausgang des UND-Glieds kurzzeitig auf "high" gesetzt, wodurch der Dirac-Impuls erzeugt wird. Die Dachbreite (Spitzenwert) des Dirac-Impulses liegt dabei wie in Fig.4 veranschaulicht sogar bei etwa 250 ps. Mit diesem Dirac-Impuls wird nun der Spitzengleichrichter 22 angesteuert, d.h. für die Zeitdauer des Dirac-Impulses werden die sehr schnellen Schottkydioden 36 elektrisch leitend geschalten und das aktuelle Testsignal von der LUT 10 wird für diese Zeitdauer an den Speicherkondensator 36 übertragen. Dieser Spannungswert ist dann für die Zeitdauer einer Taktgeberperiode, also für 10 µs, am Speicherkondensator 34 gespeichert. Diese Zeit ist ausreichend um mittels eines hochauflösenden 12-bit SAR AD-Wandlers 12 mit einer typischen Umsetzungsrate von 1 MHz (T = 1 µs) ausgelesen zu werden. Dabei ist die Änderung der Spannung am Speicherkondensator 36 während der Testperiode von 10 µs sogar so gering, dass sogar ein Oversampling mit Mittelwertbildung, also ein mehrmaliges Messen der am Speicherkondensator 36 anliegenden Spannung, möglich ist. Auf diese Weise können selbst unter Störeinflüssen verlässliche Ergebnisse gewährleistet werden.

Zwischen dem Speicherkondensator 34 und dem AD- Wandler 12 ist ein Trennverstärker 56 vorgesehen. Dieser hat einen sehr hochohmigen Eingang und belastet daher das den Speicherkondensator während der Messung nicht, so dass das am Speicherkondensator anliegende Signal während der etwa 10 µs dauernden Messphase nahezu konstant bleibt.

Mittels einer Verzögerungsschaltung 24 ist es nun möglich den Dirac-Impuls gegenüber dem Testsignal inkrementell zu verschieben. Die in Fig. 1 verwendete Verzögerungsschaltung 24, umfasst im Wesentlichen zwei programmierbare und seriell ladbare 8-bit (2⁸ = 256 Werte) Verzögerungsregister 50, 52 mit aufeinander abgestimmten Grundinkrementen. Das eine 8-bit Register 50 besitzt ein Grundinkrement von 250 ps und kann damit den Dirac-Impuls um bis zu 255 * 250 ps = 63,750 ns verzögern. Das andere 8-bit Register 52 besitzt ein Grundinkrement von 5ns, was dem 20-fachen des ersten Registers 50 entspricht. 240 Inkremente (240 * 250 ps = 60 ns) des ersten Registers 50 decken dann exakt den Zeitbereich ab, der auch durch 12 Inkremente (12 * 5 ns = 60 ns) des zweiten Registers 52 abgedeckt werden kann. Durch eine Kaskade der beiden Register 50, 52 kann daher ein lückenloses Zeitraster mit einem kleinsten Zeitinkrement von 0,25 ns über einen Gesamtbereich von t_{ges} = (21 + 1) * 60 ns = 1,32 µs erreicht werden. Zusätzlich ist ein Verzögerungscontroller 54 vorgesehen, mit dem der Dirac-Impuls über einen zusätzlichen Offset von ganzzahligen Vielfachen von 1,32 µs verzögert werden kann, so dass dann die gesamte Taktperiode von 10 µs ausgenutzt werden kann.

Der Frequenzgenerator 28 erzeugt das Rechtecksignal periodisch mit einer Frequenz von 100 kHz, d.h. alle 10 µs wird ein neuer Rechteckimpuls generiert. Über den Dirac-Impuls wird ein dezidierter und begrenzter, nämlich 250 ps dauernder, Zeitabschnitt des reflektierten Signals herausgepickt und ausgewertet. Durch das inkrementelle zeitliche Verschieben des Dirac-Impulses gegenüber dem Rechtecksignal bzw. gegenüber dem zu untersuchenden Testsignal der LUT, wird das Testsignal schrittweise ausgewertet. Durch diese schrittweise Auswertung wird der Spannungsverlauf im Original-Zeitbereich, welcher Änderungen im 100 ps-Bereich aufweist um 5 Zehnerpotenzen in den 10 µs Zeitbereich transponiert. Die zeitliche Folge der Messwerte im transponierten Zeitbereich stellt dabei eine repräsentative, konforme Abbildung des Testsignals im Originalzeitbereich dar. Auf diese Weise kann daher auch mit einem relativ langsamen AD-Wandler 12 eine hochauflösende Erfassung des Original-Testsignals erreicht werden.

Das Inkrement der Verzögerungsschaltung 24 muss bei der vorliegenden Vorrichtung auf die Dachbreite des Dirac-Impulses abgestimmt sein. Die Dachbreite des Dirac-Impulses stellt dabei die untere Grenze für das Zeitinkrement dar. In Fig. 1 ist die Dachbreite durch die Spezifikationen der Logikschaltung 38 bestimmt und ergibt eine Dachbreite des Dirac-Impulses von 250 ps. Die effektiv wirksame Dauer des DIRAC-Impulses, die sog. Dachbreite darf den Wert des Zeitinkrementes nicht überschreiten. Verzögerungsschaltungen 24 mit anderen Zeitinkrementen sind kommerziell erhältlich.

Statt einer kaskadierten Verzögerungsschaltung 24 können auch gleichermaßen hochauflösende Verzögerungsglieder mit 8-bit, 10-bit oder mehr Stellen verwendet werden. Eine kaskadierte Verzögerungsschaltung hat aber demgegenüber den Vorteil, dass das feine Zeitraster des Verzögerungsgliedes mit dem Inkrement 0,250ns über einen weiten (hier 21-fachen) Zeitbereich genutzt werden kann. Der Aufwand an Verzögerungsgliedern wird hierdurch auf weniger als 10% reduziert und das Programmieren der beiden 8 bit Register stark vereinfacht.

### Bezugszeichenliste:

- 10: zu untersuchende Leitung (line under test - LUT)
- 12: AD-Wandler
- 14: grafisches Display
- 20: Abtast-Halte-Glied
- 22: Spitzengleichrichter
- 24: Verzögerungsschaltung
- 26: Frequenzgenerator
- 28: "Pulse Performance"-Stufe
- 30: Negator-Glied
- 32: Negator-Glied
- 34: Speicherkondensator
- 36: schnelle Schottkydioden
- 38: Dirac-Generator
- 40: Negator-Glied
- 42: UND-Glied
- 44a,b: Widerstand
- 46: Widerstand
- 50: Verzögerungsglied mit 8bit Register
- 52: Verzögerungsglied mit 8bit Register
- 54: Verzögerungscontroller
- 56: Trennverstärker

## Patentansprüche

1. Zeitbereichsreflektometer zur Ermittlung und Analyse von Lauflängen und Reflexionscharakteristika von elektromagnetischen Wellen und Signalen, umfassend:
- einen Impulsgenerator (26) zur Erzeugung einer Impulsserie mit der die zu untersuchende Leitung (10) beaufschlagt wird,
- eine Verzögerungsschaltung (24) zur inkrementellen Abtastung periodischer Testsignale,
- ein Abtast-Halte-Glied (20) zur Aufnahme und Zwischenspeicherung der momentanen Amplitude des Testsignals,
- einen AD-Wandler (12), zur Umwandlung des analogen Testsignals in einen digitalen Wert, und
- ein grafisches Display (24) zur Anzeige des erfassten Testsignals,
**dadurch gekennzeichnet, dass**
das Abtast-Halte-Glied (20) als separates Schaltungselement dem AD-Wandler (12) vorangeschaltet ist und einen Spitzengleichrichter (22) sowie einen Speicherkondensator (34) umfasst,
wobei der Spitzengleichrichter (22) zwei entgegengesetzt geschaltete, sehr schnelle Schottky-Dioden (36) mit gemeinsamer Anode umfasst und
wobei der Spitzengleichrichter (22) mittels eines Dirac-Impulses, der von einem Dirac-Generator (38) erzeugt wird, angesteuert wird,
so dass das während der Ansteuerung durch den Dirac-Impuls aufgenommene Testsignal für in etwa der Zeitdauer der Periode des Impulsgenerators (26) an dem Speicherkondensator (34) anliegt.

2. Ein Zeitbereichsreflektometer gemäß Anspruch 1, wobei der Spitzengleichrichter (22) aus zwei entgegengesetzt geschalteten, sehr schnellen Schottky-Dioden (36) besteht.

3. Ein Zeitbereichsreflektometer gemäß Anspruch 1 oder 2, wobei der Dirac-Impuls kürzer als 3 ns und die Periode des Impulsgenerators (26) größer als 100 ns ist, vorzugsweise wobei der Dirac-Impuls kürzer als 1 ns und die Periode des Impulsgenerators (26) größer als 1 µs ist, und weiter vorzugsweise wobei der Dirac-Impuls in etwa 250 ps und die Periode des Impulsgenerators (26) etwa 10 µs beträgt.

4. Ein Zeitbereichsreflektometer gemäß Anspruch 3, wobei der Dirac-Generator eine Logikschaltung (38) darstellt, deren Logikgatter (40, 42) im Grenzbereich ihrer Betriebsspannung betrieben werden.

5. Ein Zeitbereichsreflektometer gemäß einem der vorangehenden Ansprüche, wobei die Verzögerungsschaltung (24) zwei Verzögerungsglieder (50, 52) und optional einen Verzögerungscontroller (54) aufweist, wobei die Zeitinkremente der Verzögerungsglieder (50, 52) derart aufeinander abgestimmt sind, dass ein hochauflösendes, äquidistantes Zeitraster erzeugt werden kann.

6. Ein Zeitbereichsreflektometer gemäß einem der vorangehenden Ansprüche, umfassend eine "Pulse Performance"-Stufe (28) in der die Flankensteilheit des Testimpulses deutlich erhöht wird.

7. Ein Zeitbereichsreflektometer gemäß Anspruch 7, wobei die "Pulse Performance"-Stufe (28) eine Logikschaltung umfasst, dessen Logikgatter (30, 32) im Grenzbereich ihrer Betriebsspannung betrieben werden.

8. Ein Zeitbereichsreflektometer gemäß einem der vorangehenden Ansprüche, wobei der AD Wandler (12) ein 10- oder 12-bit SAR AD-Wandler ist.

9. Zeitbereichsreflektometrieverfahren zur Ermittlung und Analyse von Lauflängen und Reflexionscharakteristika von elektromagnetischen Wellen und Signalen, unter Verwendung eines Zeitbereichsreflektometers gemäß einem der vorangehenden Ansprüche.
